# EUROPEAN PATENT SPECIFICATION

(11) **EP 0 757 854 B1**
(45) Date of publication and mention of the grant of the patent: **25.08.1999**
(21) Application number: 95918232.0
(22) Date of filing: 25.04.1995
(51) Int. Cl.: H02H 3/00

(54) **A WINDOW DISCRIMINATOR CONTROLLED CURRENT BREAKER**
FENSTER-KOMPARATORGESTEUERTER LEISTUNGSSCHALTER
INTERRUPTEUR COMMANDE PAR UN DISCRIMINATEUR A FENETRES

(30) Priority: 25.04.1994 SE 9401397
(43) Date of publication of application: 12.02.1997
(73) Proprietor: Lönn, Per, 133 37 Saltsjöbaden (SE)
(72) Inventor: Lönn, Per, 133 37 Saltsjöbaden (SE)
(74) Representative: Sundström, Per Olof
(86) International application number: SE9500454
(87) International publication number: WO9529525

(56) References cited:
- EP-A- 0 374 417
- WO-A-93/09634

## Description

The present invention relates to a device for breaking the supply of current to a mains connected electronic apparatus having at least two different normal alternative current consumption levels due to the equipment current consumption deviating from one of these consumption levels, wherein the device includes a current breaker which is connected in series with the current consumption line of the equipment.

It is well known that a strong indication of a malfunction in electronic equipment which is normally mains connected is when the equipment current consumption/power consumption begins to deviate from a normal consumption level. In this regard it has been realized that when a malfunction occurs, it is important to quickly cut-off the supply of current to the equipment in order to prevent subsequent events in the form of smoke, fire, short-circuiting, etc., that may occur should the malfunction be allowed to continue. It is also known to connect-up the equipment current supply line through the medium of a current breaker provided with a window discriminator which accepts a current consumption/power consumption within given window limits, and which therewith permits the current breaker to conduct current to the equipment provided that consumption lies within the window, whereas the discriminator is constructed to otherwise cause the current breaker to isolate the equipment from the mains/current source.

Such window discriminator controlled current breakers are well known to the art; c.f. EP-A2 0,374,417, DE-A1 6,924,419 and US-A 3,934,239.

However, the use of a known circuit breaker construction in the case of electronic equipment whose power consumption markedly varies or which have two or more different normal alternative current consumption levels, is not convenient because it is necessary to make the circuit breaker window so wide as to make it impossible to detect in a meaningful way deviations from the window limits that are significant with regard to malfunctions. For instance, the window discriminator is unable to detect a malfunction in the form of overcurrent or excess current occurring from a region in the vicinity of the bottom limit of the window, or to detect an "undercurrent" on the basis of a current level in the vicinity of the upper limit of the window.

The object of the present invention is to provide a device which will safeguard against fires or other consequential damage to mains connected electronic equipment that has at least two different normal alternative current consumption levels, when the current consumption/power consumption of the equipment deviates significantly from one of the alternative normal power levels/current consumption levels.

The invention is defined in the following Claim 1.

Further developments of the invention are set forth in the dependent Claims.

The invention is based on the concept of providing for connection between the mains supply and the electronic equipment a current breaker which has at least two window discriminators, one for each alternative normal equipment power consumption level/equipment current consumption level, said window discriminators being adapted so that the different equipment current consumption levels will each lie within a respective window, wherein the discriminators are adapted to trigger activation of the current breaker, i.e. to cause the current breaker to break the supply of current to the equipment, when the equipment current consumption does not lie within any one of the windows.

Naturally, the inventive device may include more than two windows, so that it can be used with equipment that has more than two normal current consumption levels. In order to enable the inventive device to be adapted to different equipment having mutually different normal current consumption levels and different permitted variations in normal current consumption at respective levels, the inventive device may be provided with adjustment means for setting the limits of the different discriminator windows and therewith adapt the device to the respective current consumption levels of a given piece of equipment.

When the inventive device shall be used with equipment having a first current consumption level which corresponds to an equipment stand-by state, and a second current consumption level which corresponds to an operational state of the equipment, the discriminator window of the device may have preset magnitudes for the first and the second levels, and the operating devices may be adapted to permit respective windows to be displaced so as to cover respective current consumption levels of the equipment concerned. The device may also include an exposed light-emitting diode which lights up when a discriminator window covers the instantaneous power consumption of the equipment.

The device may also be provided with a conventional resetting device which enables the circuit breaker to be reset manually after having been released.

The device may advantageously be formed by a housing unit which carries an electrical contact for connection to a mains outlet, and which includes a socket connection for a plug contact on a mains connecting cable belonging to the equipment.

According to preferred embodiments, the window discriminators of the device may be adapted generally for adjustment to a stand-by level and to an operational level of current consumption of conventional remote control equipment, such as a TV-set.

The control devices activated by the window discriminators will conveniently have a time delay function which will allow the equipment current consumption to be reset to the different levels without releasing the current breaker, within a predetermined permitted resetting time.

The discriminators are suitably connected to a circuit which will prevent the circuit breaker being triggered or released when the level of current consumed by the equipment lies within the setting of a discriminator window.

It will be understood that the inventive device finds general use with current-consuming equipment that have at least two different current consumption levels, wherein the levels can be considered to have typical variation limits so that a clear indication of a malfunction will lie in the extent to which current consumption within the limits of said current consumption level deviates from said level limits.

The invention is well suited for use with TV-sets that have a stand-by function.

The inventive device can also be used beneficially with music and audio systems. However, because the amount of current consumed by such systems when in an operating state will vary markedly in relation to a mean power level, it is necessary to make the window correspondingly large or to take other appropriate measures.

It is also conceivable within the scope of the invention to couple several different pieces of electronic equipment to the mains network through the medium of one single inventive device, wherein the protection afforded these pieces of equipment will be effective when the device is designed to embrace each of the different power levels of the combination with an intrinsic discriminator window of sufficiently small size.

The invention will now be described in more detail with reference to exemplifying embodiments thereof and also with reference to the accompanying drawings, in which
- Fig. 1: is a detailed circuit diagram of an inventive device; and
- Fig. 2: illustrates schematically the outer configuration of an inventive device.

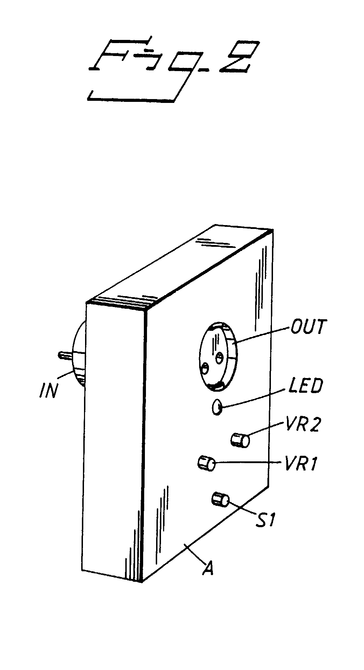

Referring first to Fig. 2, the embodiment illustrated in this Figure is based on a protective circuit breaker generally referenced A and available commercially from and manufactured by Marelko, Gothenburg, Sweden, under the trade designation Marelko M-01B, power supply & breaker.

In accordance with the invention, the circuit breaker A (Marelko M-01B) has been supplemented with the illustrated circuits and components, which for the sake of clarity have been shown outside the "wall" A of the fundamental circuit breaker. The components have been identified with conventional signs and symbols.

Referring again to Fig. 2, the circuit breaker A is supplemented with setting knobs VRl and VR2, a light-emitting diode LED and a switch Sl. The actual circuit breaker A also includes a male electrical contact IN and a female electrical contact OUT.

The operator may connect the IN side of the device to a wall socket and the electrical connection cable of, e.g., a remote controlled TV-set to the OUT side.

When the television set is now switched on to a stand-by state, the switch S1 is manually pressed-in at the same time, so as to prevent the circuit breaker unit A from immediately breaking the current supply or from breaking the current supply after a short space of time has lapsed. With the switch S1 pressed in, the operator turns the knob VRl until the light emitting diode LED lights up. The idling current supplied to the television set in its stand-by state will now lie within a discriminator window and the circuit breaker unit A will automatically break the supply of current to the television set should the current consumed by the television set in its stand-by state deviates from the set window value.

The operator can now adjust the television set to its operational state, with the switch S1 being held pressed-in and the knob VR2 turned until the light-emitting diode lights up, so that the current consumed by the television set in its operational state also lies within a predetermined window.

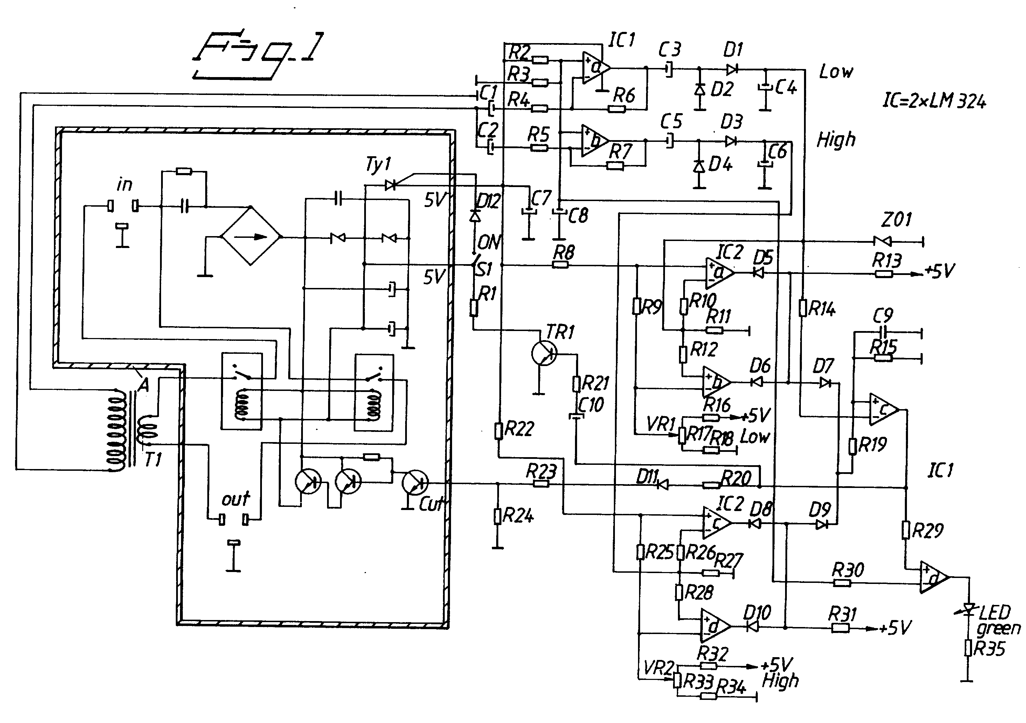

The circuit defines time constants which prevent the circuit breaker A from momentarily breaking the supply of current should the current consumption momentarily deviate from a discriminator window. The circuit is also designed to accept when the connected equipment, for instance the television set, is disconnected, for instance through its main switch. This is achieved in the exemplifying embodiment of Fig. 1, by coupling in R14. Illumination of the light-emitting diode LED indicates that current is available from the current breaker A.

The aforementioned time constants, which after a short period of time would cause the circuit breaker relays to break the current supply, are defined, e.g., by C4, C6, R15-C9, R21-C10, and others. These time constants are neutralized by closing the switch S1 and holding the switch closed while setting the windows with the aid of the knobs VR1, VR2.

The consumption currents to be measured are isolated from the network and converted to appropriate relative measuring voltages in the current transformer T1, which is essentially loaded by C2, R5, R7.

This load can be accepted when no absolute values are required.

When the absolute values of the measuring signal are low, particularly in the lower current regions, it is necessary to amplify the AC signal in order to obtain a correct DC signal. This is effected in ICla and b.

The amplification in IC1a for the "low" current region is substantially greater than in the operational amplifier IClb, which is otherwise identically coupled. As a result, the two rectifying couplings C3-D1-D2-C4 and C5-D3-D4-C6 deliver DC measuring signals which lie well within the available dynamic range of the chosen, permitted "current windows", even at supply voltages as low as 5V.

These measuring voltages are delivered to the operational amplifiers IC2a, b, c and d, used as comparators. IC2 is coupled to function as two mutually independent window discriminators. IC2a and IC2b form "low" window discriminators and IC2c and IC2d form a "high" window discriminator. Since these circuits are identical to each other, only IC2a and b will be discussed.

The negative input on IC2a is connected to the positive input on IC2b via R10-R12. The measuring signal is applied to the junction node between R10 and R12, and is loaded with R11 to earth.

A fixed voltage, although adjustable via VR1, is applied from R16-R18 to the negative input on IC2b and, via the hysteresis resistance R9, to the positive input on IC2a. The hysteresis function is balanced by R8.

As a result, the outputs of the two operational amplifiers will pass to a high state only when the value of the measuring signal lies within the hysteresis of the value set by the setting knob VR1. In this regard, none of the diodes D5 or D6 will load the line which is high via R13. The high signal which reaches the positive input on IC1c via D7 and R19 is then higher than the signal which reaches the negative input via R14, since this signal is limited by ZD1, despite the occurrence of a saturated signal o OC1a. The pin 8 of the integrated circuit IC1c therewith goes high. The positive input on IC1d goes high, via R29, and the light-emitting diode LED lights up. At the same time, the power unit M-01B is commanded to hold the relays drawn, i.e. the circuit closed, via R20, D11, R23.

TR1 together with R1 and the time constant R21-V10 short-circuit momentarily the +5V supply and herewith ensure that Ty1 is extinguished.

## Claims

1. A device for breaking the current supply to mains-connected electronic equipment having at least two different normal alternative current consumption levels due to deviation of the current consumption of the equipment deviating from one of these current consumption levels, wherein the device includes a circuit breaker which is connected in series with the current supply line of the equipment, wherein: the device further includes a window discriminator for each power level; and the discriminators are connected to control means functioning to cause the circuit breaker to isolate the current supply from the equipment when the current consumption of said equipment does not lie within one of the windows.

2. A device according to Claim 1, **characterized** by setting means for setting the window limits to respective current consumption levels.

3. A device according to Claim 1 or Claim 2 for use with equipment having a first current consumption level corresponding to an equipment stand-by state, and a second current consumption level corresponding to an equipment operational state, **characterized** in that the discriminator window of the device for the first level and for the second level have preset window sizes; and that the setting means functions to permit respective windows to be displaced to cover the respective levels of the equipment coupled via the device.

4. A device according to Claim 3, **characterized** by a light-emitting diode which is visible on the device housing and which is intended to light up when the discriminator window covers the instant level of current consumption of the equipment connected to the device.

5. A device according to any one of Claims 1 to 4, **characterized** by resetting means for resetting the circuit breaker to a coupled state after having been released from said state.

6. A device according to any one of Claims 1 to 5, **characterized** in that the device includes a housing which has an electrical contact for connection to a mains socket and an electrical contact for connection to a mains connection cable belonging to the equipment.

7. A device according to any one of Claims 1 to 6, **characterized** in that the window discriminators are adapted generally to a stand-by level and operational level of equipment, such as a television set, which can be coupled to an operational state by remote control.

8. A device according to any one of Claims 1 to 7, **characterized** in that the control means has a time delay function which will permit the current consumption of the equipment to be reset to the different levels within a predetermined permitted resetting time, without triggering the current isolating function of the circuit breaker.

9. A device according to any one of Claims 1 to 8, **characterized** in that the control means connected to the discriminators is intended to prevent triggering of the circuit breaker to its current isolating state when a current consumption level of the equipment lies within a discriminator window.

10. A device according to any one of Claims 1 to 9, **characterized** by means for preventing the circuit breaker from isolating the supply of current to the equipment when the equipment is set to a state in which no current is consumed.

## Patentansprüche

1. Eine Vorrichtung zum Unterbrechen der Stromzufuhr zu einer netzverbundenen elektronischen Einrichtung, welche mindestens zwei verschiedene normale alternative Stromverbrauchsniveaus aufweist aufgrund einer Abweichung des Stromverbrauchs der Einrichtung, welche von einem dieser Stromverbrauchsniveaus abweicht, wobei die Vorrichtung einen Trennschalter enthält, welcher mit der Stromzufuhrleitung der Einrichtung in Reihe verbunden ist, wobei die Vorrichtung ferner einen Fenster-Diskriminator für jedes Leistungsniveau enthält und die Diskriminatoren mit Steuermitteln verbunden sind, welche so wirken, daß sie den Trennschalter veranlassen, die Stromzufuhr von der Einrichtung zu isolieren, wenn der Stromverbrauch der Einrichtung nicht innerhalb eines der Fenster liegt.

2. Vorrichtung nach Anspruch 1, **gekennzeichnet durch** Einstellmittel zum Einstellen der Fenstergrenzen auf entsprechende Stromverbrauchsniveaus.

3. Vorrichtung nach Anspruch 1 oder 2 zur Verwendung mit einer Einrichtung, welche ein erstes Stromverbrauchsniveau entsprechend einem Einrichtungs-Stand-by-Zustand und ein zweites Stromverbrauchsniveau entsprechend einem Einrichtungs-Betriebszustand aufweist, **dadurch gekennzeichnet**, daß das Diskriminator-Fenster der Vorrichtung für das erste Niveau und für das zweite Niveau voreingestellte Fenstergrößen aufweist, und daß das Einstellmittel so wirkt, daß es erlaubt, die betreffenden Fenster so zu versetzen, daß sie die betreffenden Niveaus der Einrichtung, welche über die Vorrichtung verbunden ist, abdecken.

4. Vorrichtung nach Anspruch 3, **gekennzeichnet durch** eine Leuchtdiode, welche auf dem Vorrichtungsgehäuse sichbar ist und welche aufleuchten soll, wenn das Diskriminator-Fenster das augenblickliche Niveau des Stromverbrauchs der mit der Vorrichtung verbundenen Einrichtung abdeckt.

5. Vorrichtung nach einem der Ansprüche 1 bis 4, **gekennzeichnet durch** Rückstellmittel zum Zurückstellen des Trennschalters auf einen verbundenen Zustand, nachdem er von diesem Zustand gelöst wurde.

6. Vorrichtung nach einem der Ansprüche 1 bis 5, **dadurch gekennzeichnet**, daß die Vorrichtung ein Gehäuse enthält, welches einen elektrischen Kontakt zur Verbindung mit einer Netzsteckdose und einen elektrischen Kontakt zur Verbindung mit einem Netzverbindungskabel, welches zu der Einrichtung gehört, aufweist.

7. Vorrichtung nach einem der Ansprüche 1 bis 6, **dadurch gekennzeichnet**, daß die Fenster-Diskriminatoren im allgemeinen an ein Stand-by-Niveau und ein Betriebs-Niveau der Einrichtung angepaßt sind, wie bei einem Fernsehgerät, welches durch Fernsteuerung in einen Betriebszustand geschaltet werden kann.

8. Vorrichtung nach einem der Ansprüche 1 bis 7, **dadurch gekennzeichnet**, daß das Steuermittel eine Zeitverzögerungsfunktion hat, welche es ermöglicht, daß der Stromverbrauch der Einrichtung innerhalb einer vorbestimmten erlaubten Rückstellzeit auf die verschiedenen Niveaus zurückgestellt wird, ohne die Stromisolierungs-Funktion des Trennschalters auszulösen.

9. Vorrichtung nach einem der Ansprüche 1 bis 8, **dadurch gekennzeichnet**, daß das Steuermittel, welches mit den Diskriminatoren verbunden ist, ein Auslösen des Trennschalters in seinen stromisolierenden Zustand verhindern soll, wenn ein Stromverbrauchsniveau der Einrichtung innerhalb eines Diskriminator-Fensters liegt.

10. Vorrichtung nach einem der Ansprüche 1 bis 9, **gekennzeichnet durch** Mittel zum Verhindern, daß der Trennschalter die Stromzufuhr zur Einrichtung isoliert, wenn die Einrichtung auf einen Zustand eingestellt ist, in welchem kein Strom verbraucht wird.

## Revendications

1. Un dispositif pour interrompre l'alimentation en courant électrique d'un équipement électronique branché sur le secteur et présentant au moins deux niveaux différents normaux de consommation en courant alternatif prévus pour le cas où la consommation en courant électrique de l'équipement s'écarte de l'un de ces niveaux de consommation de courant électrique; le dispositif qui comporte un interrupteur de circuit qui est relié en série à la ligne d'alimentation en courant de l'équipement, dans lequel : le dispositif comporte en outre un discriminateur à fenêtres pour chaque niveau de puissance ; et dans lequel les discriminateurs sont reliés à des moyens de contrôle fonctionnant pour obliger l'interrupteur de circuit à isoler l'alimentation en courant électrique de l'équipement lorsque la consommation de courant dudit équipement ne se trouve pas dans l'une des fenêtres.

2. Un dispositif selon la revendication 1, caractérisé par des moyens de fixation pour fixer aux fenêtres des limites aux niveaux respectifs de consommation de courant.

3. Un dispositif selon la revendication 1 ou la revendication 2, destiné à être utilisé avec de l'équipement présentant un premier niveau de consommation de courant correspondant à un équipement à l'état d'attente, et un deuxième niveau de consommation de courant correspondant à un état de fonctionnement de l'équipement, caractérisé en ce que la fenêtre de discriminateur du dispositif pour le premier niveau et pour le deuxième niveau présentent des tailles de fenêtres présélectionnées; et en ce que les moyens de fixation fonctionnent pour permettre aux fenêtres respectives d'être déplacées pour couvrir les niveaux respectifs de l'équipement couplé via le dispositif.

4. Un dispositif selon la revendication 3, caractérisé par une diode émettrice de lumière qui est visible sur le boîtier du dispositif et qui est destinée à s'allumer lorsque la fenêtre de discriminateur couvre le niveau instantané de consommation de courant de l'équipement relié au dispositif.

5. Un dispositif selon l'une quelconque des revendications 1 à 4, caractérisé par des moyens de remise en position pour remettre en position l'interrupteur de circuit à un état couplé après qu'il ait été libéré dudit état.

6. Un dispositif selon l'une quelconque des revendications 1 à 5, caractérisé en ce que le dispositif comporte un boîtier qui présente un contact électrique pour la liaison à une prise du secteur et un contact électrique pour la liaison à un câble de connexion au secteur appartenant à l'équipement.

7. Un dispositif selon l'une quelconque des revendications 1 à 6, caractérisé en ce que les discriminateurs à fenêtres sont aptes généralement à un niveau d'attente et à un niveau de fonctionnement de l'équipement, tel qu'un appareil de télévision qui peut être couplé à un état de fonctionnement par télé-commande.

8. Un dispositif selon l'une quelconque des revendications 1 à 7, caractérisé en ce que les moyens de commande présentent une fonction de retard temporel qui permettra à la consommation de courant de l'équipement d'être remise en position aux différents niveaux pendant une durée de remise en position permise prédéterminée, sans déclencher la fonction d'isolation de courant de l'interrupteur de circuit.

9. Un dispositif selon l'une quelconque des revendications 1 à 8, caractérisé en ce que les moyens de commande reliés aux discriminateurs sont destinés à empêcher le déclenchement de l'interrupteur de circuit vers son état d'isolation de courant, lorsqu'un niveau de consommation de courant de l'équipement se trouve dans une fenêtre de discriminateur.

10. Un dispositif selon l'une quelconque des revendications 1 à 9, caractérisé par des moyens pour empêcher l'interrupteur de circuit d'isoler l'alimentation en courant de l'équipement, lorsque l'équipement est placé vers un état dans lequel aucun courant n'est consommé.
